# EUROPEAN PATENT APPLICATION

(11) **EP 2 913 848 A1**
(43) Date of publication of application: **02.09.2015**
(21) Application number: 14157035.8
(22) Date of filing: 27.02.2014
(51) Int. Cl.: H01L 21/78, H01L 21/768

(54) **Dicing method**

(71) Applicant: ams AG, 8141 Unterpremstätten (AT)
(72) Inventor: Stering, Bernhard, 8510 Stainz (AT); Schrank, Franz, 8052 Graz (AT); Schrems, Martin, 8063 Eggersdorf (AT)
(74) Representative: Epping - Hermann - Fischer

(57) **Abstract**

The dicing method comprises the steps of providing a substrate (1) of semiconductor material, which has a main surface (10), where integrated components (3) are arranged, and a rear surface (11) opposite the main surface, forming trenches (20) in the substrate from the main surface by etching, and forming rear trenches (21) in the substrate from the rear surface by sawing, according to the location of the trenches, thus dividing the substrate into chips (13). The trenches are formed with a lateral width (w) of typically less than 20 µm, the rear trenches are formed with a further lateral width (W), and the lateral width is smaller than the further lateral width.

## Description

Semiconductor chips are usually produced on semiconductor wafers, which are conventionally diced into single chips by sawing. Currently known dicing methods also include laser dicing and trench dicing or suitable combinations thereof. These methods are used to divide the wafer along sawing streets surrounding each chip and are part of the packaging process. In case of trench dicing a masking layer is structured by a lithographic process to define the sawing streets. The structured masking layer is then used as a mask in an etching step to produce trenches in the semiconductor wafer along the sawing streets, preferably by deep reactive ion etching (DRIE). Trench dicing has the advantage that the spaces between the chips can be much smaller compared to conventional sawing, and the productivity is higher than in laser dicing. Trench dicing allows the lateral width of the sawing streets to be reduced from typically about 60 µm to 20 µm or even smaller. The smaller the sawing street, the larger is the yield of good die per wafer. Contrary to a sawing method, trench dicing avoids the risk of small pieces breaking off from the chip edges during dicing. Therefore trench dicing is increasingly used for packaging of semiconductor chips.

WO 2012/143353 A1 discloses a dicing method wherein a trench is formed at a first surface of a carrier comprising electrical components. The carrier is cut through from a second surface opposite the first surface. Thus the material is prevented from breaking out of the carrier during dicing. US 6,420,776 B1 discloses a method of opening the scribeline at the front side, attaching a holding material such as a tape to silicon dioxide, and then forming groove-type trenches from the backside of wafer opposite the IC by a laser to a desired depth, and finally mechanically cracking the remaining silicon thickness below the scribeline to release the dies.

US 6,573,156 B1 discloses a method for singlation of chips by etching a first trench, filling the trench with a holding material such as parylene, etching a second trench from the backside, removing the holding material by dry etching and releasing the chips.

US 7,482,251 B1 discloses a method of singlation of dies by etching a trench from the top side of the wafer, forming underbump metallization and bumps on the top side and releasing the chips by removing the semiconductor material from the bottom side of the wafer until the trenches are opened.

US 7,566,634 B2 discloses a further method for trench dicing of chips in wafer level packaging (WLP).

US 8,021,923 B2 discloses a method of producing through-hole vias formed along the sawing streets by a partial sawing process to allow stacking of chips. Pads are connected to a via hole formed within organic material such as polyimide within a sawing street that has been partially etched.

US 8,153,464 B2 discloses a method of singulating a semiconductor die from a wafer by etching trenches into the wafer, depositing a passivation layer into the trenches to form a plug on the bottom of the trenches to protect the dies and immobilize them during singulation, and forming a rigid carrier layer or plate at the first side of the wafer to secure the dies. The wafer is then ground from the back side to expose the bottom of each trench. A metal layer is formed on the back surface of the wafer. A dicing tape is added, the carrier layer is removed, and the die is separated from the wafer by laser cutting or by flexing the tape.

US 8,198,705 B2 discloses a method to form trenches along saw streets on the backside of the wafer opposite integrated circuits covered by a glue layer and a handling wafer. The pattern is transferred by DRIE until the glue layer is reached, and the wafer is thus divided into chips.

US 8,236,611 B1 discloses a method for die singulation using a trench etch process from the backside of a die using a first handling wafer. A second handling wafer is attached to the front side comprising integrated components.

US 2008/0153265 A1 discloses a method of die singulation by forming trenches along the sawing streets on the front side and removing the wafer from the backside until the trenches are opened and the die are released.

It is an object of the present invention to disclose a dicing method that allows exceptionally narrow sawing streets and reduces damages of the chip edges during dicing.

This object is achieved with the dicing method according to claim 1. Variants derive from the dependent claims.

The dicing method comprises the steps of providing a substrate of semiconductor material, which has a main surface, where integrated components are arranged, and a rear surface opposite the main surface, forming trenches in the substrate from the main surface by etching, and forming rear trenches in the substrate from the rear surface by sawing, according to the location of the trenches, thus dividing the substrate into chips. The trenches are formed with a lateral width and the rear trenches are formed with a further lateral width in such a manner that the lateral width is smaller than the further lateral width.

The minimal width of the sawing streets is essentially the width of the rear trenches, which is mainly defined by the width of the sawing blade. The trenches etched in the main surface do therefore not broaden the sawing streets. The rear trenches are sawn until the etched trenches are reached, so that it is not necessary to break the substrate or to apply a further cutting tool. The depth of the etched trenches is preferably adapted to prevent or at least reduce chipping of substrate material at lateral edges of the chips, in particular in the vicinity of the main surface, and the rear trenches are confined to a range well below the main surface.

In a variant of the method, the lateral width of the trenches is less than 20 µm.

In a further variant of the method, the lateral width of the trenches is less than 15 µm.

In a further variant of the method, the lateral width of the trenches is less than 10 µm.

In a further variant of the method, the further lateral width is more than twice as large as the width of the trenches.

In a further variant of the method, the further lateral width is more than three times as large as the width of the trenches.

In a further variant of the method, the further lateral width is smaller than 20 µm.

In a further variant of the method, the further lateral width is in the range from than 20 µm to 30 µm.

In a further variant of the method, the further lateral width is larger than 30 µm.

In a further variant of the method, the sawing of the rear trenches is stopped in the substrate at a distance of more than 40 µm from the main surface. In this case the etched trenches are more than 40 µm deep, preferably reaching to a distance of more than 50 µm from the main surface.

In a further variant of the method, the sawing of the rear trenches is stopped in the substrate at a distance from the main surface in the range from 30 µm to 40 µm. In this case the etched trenches are more than 30 µm deep, preferably reaching to a distance of more than 40 µm from the main surface.

In a further variant of the method, the sawing of the rear trenches is stopped in the substrate at a distance from the main surface in the range from 20 µm to 30 µm. In this case the etched trenches are more than 20 µm deep, preferably reaching to a distance of more than 30 µm from the main surface.

In a further variant of the method, a dielectric layer is arranged on the main surface, and the trenches are etched through the dielectric layer.

In a further variant of the method, the trenches are etched before the rear trenches are sawn.

In a further variant of the method, through-substrate vias are formed in the substrate before the trenches are etched and before the rear trenches are sawn.

The following is a detailed description of examples of the dicing method.
- Figure 1: is a cross section of an example of a wafer after the application of the dicing method.
- Figure 2: is a cross section of a wafer comprising integrated components and a wiring.
- Figure 3: is a cross section according to Figure 2 after an application of a handling wafer.
- Figure 4: is a cross section according to Figure 3 after the formation of a through-substrate via and a rear metallization.
- Figure 5: is a cross section according to Figure 4 after an application of a further handling wafer.
- Figure 6: is a cross section according to Figure 5 after etching of trenches.
- Figure 7: is a cross section according to Figure 6 showing a sawing step.

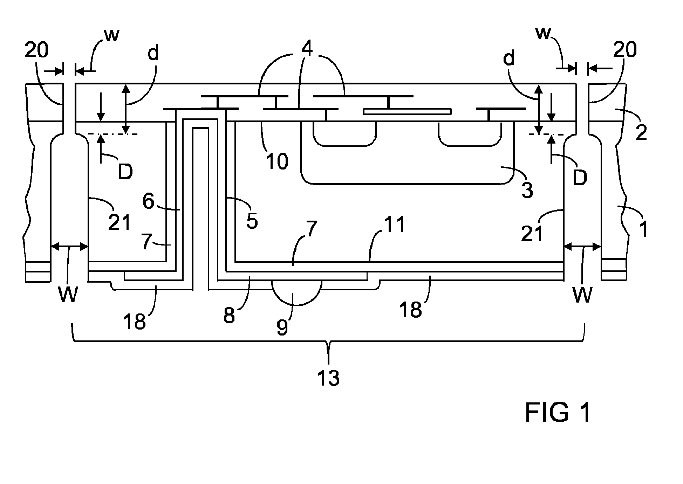

Figure 1 is a cross section of an example of a wafer after the application of the dicing method. The wafer comprises a substrate 1 of semiconductor material like silicon, for instance. A dielectric layer 2 is arranged on or above a main surface 10 of the substrate 1. The dielectric layer 2 may be a single layer or a sequence of layers, which may comprise different dielectric materials. The dielectric layer 2 may be silicon dioxide, for instance, and its surface may be formed by a passivation like silicon nitride, for instance. Integrated components 3 can be formed at or near the main surface 10. Structured metal layers 4 can be embedded in the dielectric layer 2 and interconnected to form a wiring of the integrated components 3. At least one through-substrate via 5 comprising a metallization 6, which is preferably insulated from the substrate 1 by a further dielectric layer 7, may be provided to connect one of the metal layers 4 with a rear metal layer 8 at the rear surface 11 of the substrate 1 opposite the main surface 10. Although the method is especially favourable for dicing wafers comprising through-substrate vias 5, as represented in the appended figures by way of example, the through-substrate via is optional, and the method can be applied to other devices, which may also comprise sensors, for instance. Bumps 9 may be provided for an external electrical connection of the rear metal layer 8, which may also form a redistribution layer or the like. A passivation layer 18 may be applied above the rear surface 11 to cover the further dielectric layer 7 and the rear metal layer 8, respectively. The passivation layer 18 is provided with openings for the bumps 9.

Trenches 20 are formed along boundaries between the regions of the substrate 1 that are each provided for one of the chips 13 into which the substrate is to be separated. The trenches 20 have a lateral width w, which may typically be less than 20 µm, for example, and may especially reach from an upper surface 12 of the dielectric layer 2 into the substrate 1. The lateral width w may especially be less than 15 µm or even less than 10 µm. The total depth d of the trenches 20, including the thickness of the dielectric layer 2 and being measured from the surface 12 perpendicularly down into the substrate 1, can be more than twice as large as the lateral width w and can be typically in the range from 30 µm to 70 µm, for instance. The trenches 20 can be etched according to conventional methods. If the dielectric layer 2 is present, two or more succeeding etching steps can be performed with etching agents and/or etching parameters being adjusted to the different materials of the dielectric layer 2 and the substrate 1. These etching procedures are known per se from semiconductor technology.

Rear trenches 21 are sawn from the rear surface 11 into the substrate 1. The rear trenches 21 have a further lateral width W, which is larger than the lateral width w and may especially be more than two times as large or even more than three times as large as the lateral width w. The further lateral width W may be typically in the range from 25 µm to 40 µm. It may be smaller than 20 µm, in the range from 20 µm to 30 µm or larger than 30 µm, depending on individual requirements. If conventional, commercially available saw blades are used, the further lateral width W may be about 55 µm, for instance, but smaller dimensions are appropriate as well and may be preferred.

The trenches 20 and the rear trenches 21 are formed along sawing streets between chips. When in the course of sawing the rear trenches 21 reach the etched trenches 20, the wafer will be diced. The chip edges are smooth at least in the region of the etched trenches 20, and the sawing of the rear trenches 21 improves productivity. As the sawing streets usually form a pattern comprising a first plurality of parallel lines perpendicularly intersected by a second plurality of parallel lines, the trenches 20 and the rear trenches 21 typically form one continuous opening in the shape of a rectangular double grid. The trenches 20 and rear trenches 21 are therefore not meant to be individual openings that are separated from one another, but intersecting trenches are included in the patterns that are suitable for an application of this method.

The distance D between the rear trenches 21 and the main surface 10 can be defined with a precision of ±5 µm or better and may especially be larger than 40 µm, in the range from 30 µm to 40 µm or in the range from 20 µm to 30 µm, depending on individual requirements.. Before the rear trenches 21 are sawn, the depth of the trenches 20 may be larger than the final depth d shown in Figure 1. The depth of the rear trenches 21 is adapted to the depth d of the etched trenches 20, so that the rear trenches 21 reach the etched trenches 20 and provide a separation of the chips 13.

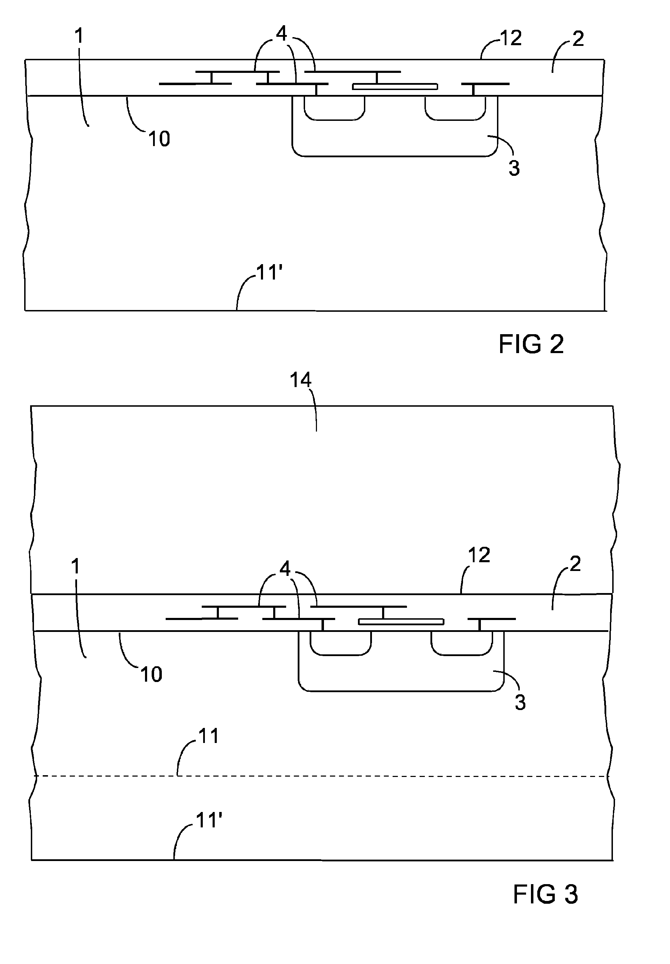

Figure 2 is a cross section of a semiconductor substrate 1 with a main surface 10 and a rear surface 11' opposite the main surface 10. A dielectric layer 2 is arranged on or above the substrate 1. The upper surface of the dielectric layer 2 is formed by the surface 12 facing away from the substrate 1. The integrated components 3, which may be CMOS components, for instance, are connected by a wiring formed by interconnected structured metal layers 4 embedded in the dielectric layer 2.

Figure 3 is a cross section according to Figure 2 after the application of a first handling wafer 14 on the dielectric layer 2. The elements of the intermediate product shown in Figure 3 that correspond to elements shown in Figure 2 are designated with the same reference numerals. The first handling wafer 14 may be bonded directly to the dielectric layer 2, or a connecting or bonding layer, which may be an oxide of the semiconductor material, for instance, can be arranged between the dielectric layer 2 and the first handling wafer 14. The use of a handling wafer and suitable bonding methods are known per se and need not be described here. The substrate 1 is thinned by grinding from the rear surface 11' until the final rear surface 11, which is indicated by the broken line in Figure 3, is reached.

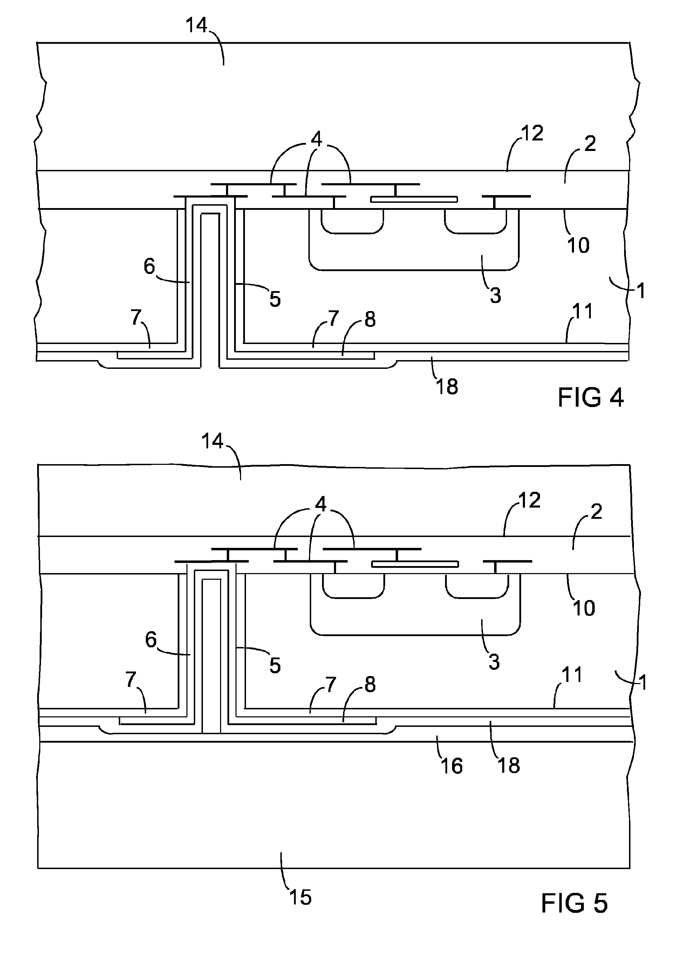

Figure 4 is a cross section according to Figure 3 after the formation of optional through-substrate vias. The elements of the intermediate product shown in Figure 4 that correspond to elements shown in Figure 3 are designated with the same reference numerals. The through-substrate via 5 is formed in an opening, which is produced in the substrate 1 from the rear surface 11 to the main surface 10 and through a portion of the dielectric layer 2 to reach one of the metal layers 4. A metallization 6 is arranged in the opening to connect the metal layer 4 with a rear metal layer 8, which may be formed together with the metallization 6 or instead applied separately. The metallization 6 is preferably insulated from the semiconductor material of the substrate 1 by a further dielectric layer 7, which may also be applied on the rear surface 11. A second handling wafer 15 is then bonded to the rear surface 11.

Figure 5 is a cross section according to Figure 4 after the application of the second handling wafer 15. The elements of the intermediate product shown in Figure 5 that correspond to elements shown in Figure 4 are designated with the same reference numerals. A connecting layer 16, which may be an oxide of the semiconductor material, for instance, can be applied to planarize the rear side and to facilitate the bonding of the flat surface of the second handling wafer 15.

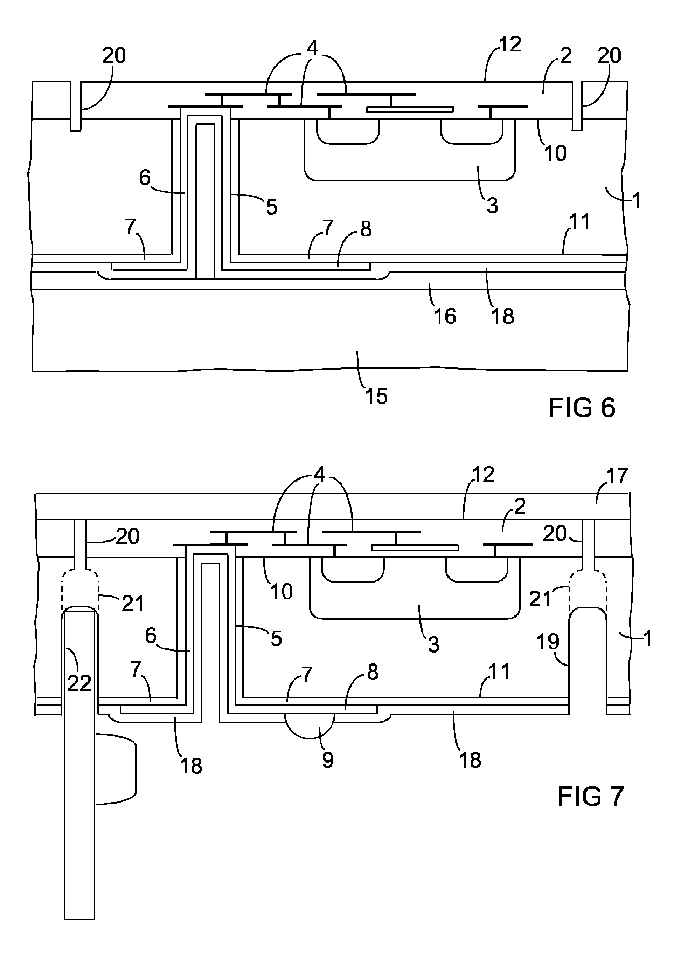

Figure 6 is a cross section according to Figure 5 after the removal of the first handling wafer 14 and after the etching of trenches 20. The elements of the intermediate product shown in Figure 6 that correspond to elements shown in Figure 5 are designated with the same reference numerals. The trenches 20 are etched from the surface 12 through the dielectric layer 2 and into the substrate 1 with an adaptation of the etching process to the different materials that are etched. The trenches 20 are etched according to a pattern of sawing streets in areas between chip portions of the wafer. A structured mask like a resist mask, for instance, which is structured according to the sawing streets by photolithography, for example, can be applied in the etching step. When the trenches 20 have been etched, the mask is removed. The second handling wafer 15 can then be removed, too.

Figure 7 is a cross section showing the state of the intermediate product according to Figure 6 after the removal of the second handling wafer 15 and during the sawing of rear trenches 21. The elements of the intermediate product shown in Figure 7 that correspond to elements shown in Figure 6 are designated with the same reference numerals. A carrier 17 may be applied to the surface 12 of the dielectric layer 2 to facilitate the handling of the wafer. The carrier 17 may be a tape, in particular an adhesive tape, which temporarily holds the chips after dicing.

Figure 7 shows a saw blade 18 in a partially cut rear trench 19. The sawing through the substrate 1 continues until the rear trenches 21 reach the etched trenches 20, as indicated by the broken lines in Figure 7. As the trenches 20 have been etched into the substrate 1, the sawing of the rear trenches 21 can be stopped at a suitable distance D from the main surface 10. If the trenches 20 have been etched to a certain distance D from the main surface 10, it will suffice to saw the rear trenches 21 to a slightly smaller distance D from the main surface 10. If the trenches 20 have been etched to a distance D of more than 20 µm from the main surface 10, for example, it will suffice to saw the rear trenches 21 to a distance D of less than 20 µm from the main surface 10. In any case the sawing continues at least until the substrate 1 is divided by the etched trenches 20 and the rear trenches 21. In this manner the arrangement of the singulated chips 13 of the diced wafer shown in Figure 1 can be obtained.

The narrow lateral width w of the etched trenches 20 corresponds to equally narrow sawing streets, which allow an exceptionally dense arrangement of the chips 13 on the wafer. Furthermore, chipping at the upper edges of the semiconductor material is prevented, because the etching process yields sufficiently smooth surfaces. Sawing from the rear side does not present serious problems, because it is only performed at locations of the substrate 1 where no components are integrated.

The method is especially suitable for the production of chips that are intended for three-dimensional integration, and in particular for the production of chips including through-substrate vias.

### List of reference numerals

- 1: substrate
- 2: dielectric layer
- 3: integrated component
- 4: metal layer
- 5: through-substrate via
- 6: metallization
- 7: dielectric layer
- 8: rear metal layer
- 9: bump
- 10: main surface
- 11: rear surface
- 11': rear surface
- 12: surface of the dielectric layer
- 13: chip
- 14: first handling wafer
- 15: second handling wafer
- 16: connecting layer
- 17: carrier
- 18: passivation layer
- 19: partially cut rear trench
- 20: trench
- 21: rear trench
- 22: saw blade
- d: depth
- D: distance
- w: lateral width
- W: further lateral width

## Claims

1. Dicing method, comprising:
- providing a substrate (1) of semiconductor material, the substrate (1) having a main surface (10), where integrated components (3) are arranged, and a rear surface (11) opposite the main surface (10),
- forming trenches (20) having a lateral width (w) in the substrate (1) from the main surface (10) by etching, and
- forming rear trenches (21) having a further lateral width (W) in the substrate (1) from the rear surface (11) by sawing, according to the location of the trenches (20), thus dividing the substrate (1) into chips (13),
**characterized in that**
- the lateral width (w) is smaller than the further lateral width (W).

2. The dicing method of claim 1, wherein
the lateral width (w) of the trenches (20) is less than 20 µm.

3. The dicing method of claim 1, wherein
the lateral width (w) of the trenches (20) is less than 15 µm.

4. The dicing method of claim 1, wherein
the lateral width (w) of the trenches (20) is less than 10 µm.

5. The dicing method of one of claims 1 to 4, wherein
the further lateral width (W) is more than twice as large as the width (w) of the trenches (20).

6. The dicing method of one of claims 1 to 4, wherein
the further lateral width (W) is more than three times as large as the width (w) of the trenches (20).

7. The dicing method of one of claims 1 to 6, wherein
the further lateral width (W) is smaller than 20 µm.

8. The dicing method of one of claims 1 to 6, wherein
the further lateral width (W) is in the range from 20 µm to 30 µm.

9. The dicing method of one of claims 1 to 6, wherein
the further lateral width (W) is larger than 30 µm.

10. The dicing method of one of claims 1 to 9, wherein
the sawing of the rear trenches (21) is stopped in the substrate (1) at a distance (D) of more than 40 µm from the main surface (10).

11. The dicing method of one of claims 1 to 9, wherein
the sawing of the rear trenches (21) is stopped in the substrate (1) at a distance (D) from the main surface (10), the distance (D) being in the range from 30 µm to 40 µm.

12. The dicing method of one of claims 1 to 9, wherein
the sawing of the rear trenches (21) is stopped in the substrate (1) at a distance (D) from the main surface (10), the distance (D) being in the range from 20 µm to 30 µm.

13. The dicing method of one of claims 1 to 12, further comprising:
arranging a dielectric layer (2) on the main surface (10) and,
etching the trenches (20) through the dielectric layer (2).

14. The dicing method of one of claims 1 to 13, wherein the trenches (20) are etched before the rear trenches (21) are sawn.

15. The dicing method of one of claims 1 to 14, further comprising:
forming through-substrate vias (5) in the substrate (1) before the trenches (20) are etched and before the rear trenches (21) are sawn.
